# EUROPEAN PATENT APPLICATION

(11) **EP 1 578 146 A1**
(43) Date of publication of application: **21.09.2005**
(21) Application number: 04006532.8
(22) Date of filing: 18.03.2004
(51) Int. Cl.: H04Q 1/14, H05K 7/14

(54) **Carrier of a distribution point in the field of telecommunications**

(71) Applicant: 3M Innovative Properties Company, Minnesota 55133-3427 (US)
(72) Inventor: Pfannkuchen, Ralf, 42111 Wuppertal (DE); Koruschowitz, Axel, 42781 Haan (DE)
(74) Representative: HOFFMANN EITLE

(57) **Abstract**

A carrier (10) of a distribution point in the field of telecommunication has a generally open, frame-like structure with at least three substantially parallel bars (12) arranged in at least two planes, the bars being maintained in a fixed relationship with each other, and at least one of the bars (12) being adapted to mount telecommunications modules (32) thereon.

## Description

### Technical Field

The invention relates to a carrier of a distribution point in the field of telecommunications as well as a distribution point comprising at least one carrier.

### Background

In the field of telecommunications numerous customers are connected with the switch of a telecommunications company via telecommunication lines. The customers can also be called subscribers. The switch is also called an exchange. Between the subscriber and the switch, sections of the telecommunication lines are connected with telecommunications modules. The telecommunications modules establish an electrical connection between a wire, which is connected at the telecommunications module at a first side, and another wire, which is connected to the telecommunications module at a second side. The telecommunications modules may comprise a housing in which wire guides are integrated. Furthermore, one or more printed circuit boards can be integrated with the telecommunications modules and can extend from the housing of a telecommunications module.

The described telecommunications modules can be located at any type of distribution point. A typical distribution point is the main distribution frame located in the central office of a telecommunications company. However, further distribution points are known in the art, such as distribution points outside the central office, which e.g. serve a number of streets or houses. Also office buildings or floors within buildings can have distribution points.

The distribution points usually comprise carriers of a suitable type, such as racks or sub-racks, to which the telecommunications modules can be mounted. These carriers can comprise a so-called back-mount frame, which has a structure that is adapted to a particular type of telecommunications module. The back-mount frames can comprise elongate, trough-like structures comprising parallel walls, to which telecommunications modules can be mounted, e.g. by latching mechanisms. The walls can comprise openings at regular intervals so as to define a predetermined spacing, or pitch, for the telecommunications modules mounted thereon. Furthermore, the applicant's subsidiary, Quante AG, based in Germany, offers a mounting system called Flexirail which is constituted by two parallel profiles having a cross-sectional configuration which is suitable for releasably mounting telecommunications modules thereon.

EP 0 498 790 A1 discloses a modular rack for accommodating printed circuit boards. Sub-assemblies are made of horizontal rods, which are connected by side plates.
Adjacent assemblies are connected by the side plates. Telecommunications modules as described above are not mountable to the disclosed structure.

WO 98/35413 describes a modular general-purpose distribution frame comprising plural hollow bodies forming a skeleton of the frame.

Finally, US 2003/0133272 A1 discloses an apparatus and method for facilitating capacity expansion of a modular frame. The apparatus comprises a housing and at least two mounting brackets, to which connection blocks can be mounted by utilizing block-mounting brackets. All of the above described racks and frames do not allow an easy change or extension of the structure thereof.

### Summary of the Invention

The invention provides a carrier of a distribution point in the field of telecommunications with increased versatility. Furthermore, this versatility is realized in a distribution point comprising at least one carrier provided by the invention.

The carrier of a distribution point in the field of telecommunications has a generally open, frame-like structure. The carrier can also be called a mounting structure and is intended to cover any structure or assembly, which allows telecommunications modules to be mounted thereon. The carrier can be a part of a rack, which is located in a distribution point in the field of telecommunications. In this context, a rack is considered a structure which can "stand alone", i.e. does typically not require a further mounting structure. As mentioned, the carrier described herein can be part of such a rack. Furthermore, it is generally possible for the carrier described herein that it also stands alone and provides an integrated structure for mounting telecommunications modules thereon.

The carrier can be provided at any type of distribution point in the field of telecommunications, e.g. a main distribution frame located in the central office of the telecommunications company, any type of intermediate distribution frame, an outside distribution point such as a cabinet located at the curb side or a distribution point provided in a building, such as an office building or on a particular floor of an office building.

The frame-like, generally open structure of the carrier is realized by at least three substantially parallel bars, which are located in at least two planes. The bars can also be called rods and encompass any elongate and, as regards the cross-section, compact element. The bars can generally be seen as mounting elements, which extend in one direction, thus forming an elongated structure. For example, the cross-section of each of the bars can be profiled in a manner suitable to mount telecommunications modules thereon. Furthermore, the cross-section of the bars can be adapted to mount one or more adapters or intermediate elements thereon. These adapters and/or intermediate elements may also have an elongate shape corresponding to the general structure of the bars. In such a modification telecommunications modules can be mounted to the adapter or intermediate elements.

The at least three substantially parallel bars of the carrier can be of the same or of different cross-sections. As the bars are located in at least two planes, their cross-section can be adapted to the particular location where a particular bar is used. In this context, the at least two planes which are defined by the at least three bars can be seen in a cross-sectional view at a right angle with regard to the extension of the bars. In such a cross-section, there will be typically two bars which define a front plane. Correspondingly, typically two bars will define a backplane, which will usually be substantially parallel with the front plane. As described in more detail below, due to different types of objects, amongst others telecommunications modules, which are to be mounted to the bars, the bars of the front plane can have a cross-section which differs from that of the backplane. However, the cross-section of all bars can be identical. In this case, the manufacturing costs can be kept at a lower level due to a high degree of standardization.

To provide an integral carrier, the bars are maintained in a fixed relationship to each other. In particular, they can be directly, or indirectly connected with each other. The maintaining of the bars in a fixed relationship to each other can be realized by any suitable structure. For example, one or more plate-like elements can be used to connect the bars with each other so as to define a generally open, frame-like structure, which will then be closed at at least one side by the described plate. However, the bars can also be connected with each other by further bars or rods extending substantially perpendicular to the bars, which are to be connected to each other.

Finally, at least one of the bars is adapted to mount telecommunications modules thereon. In a specific embodiment of the carrier described herein two substantially parallel bars cooperate to define a mounting structure for telecommunications modules. As mentioned above, the bars can advantageously have a constant cross-section. Instead or in addition thereto an adapter or intermediate element, which may have substantially the same length as the bar, can be attached to the bar. Advantageously, such an adapter or intermediate element also has a constant cross-section throughout. This provides enhanced flexibility for mounting telecommunications modules for the following reasons.

Firstly, the carrier having bars as described above does not define a predetermined pitch for mounting telecommunications modules. Rather, telecommunications modules can be mounted at any desired location along the bars and can particularly be moved along the bars by sliding them relative to the bars. Consequently, the capacity of the carrier is not limited by a predetermined pitch, but the carrier can be equipped with as many telecommunications modules as it can accommodate. Also in a situation when the configuration of telecommunications modules is to be changed, the carrier described herein permits great versatility. As described in more detail below, wire guides can be mounted to the carrier in addition to and preferably between telecommunications modules. If a need for wire guides arises, two adjacent telecommunications modules merely have to be moved apart from each other along the bars for a sufficient distance so as to mount wire guides in between. Furthermore, as there are different types of wire guides, one type of wire guide can be replaced for a different type of wire guide, when the need arises.

Furthermore, the carrier is flexible with regard to its length, i.e. its extension in the direction of the bars. As the size of the carrier is essentially only limited by the length of the bars used, these can be provided at any suitable or desired length. In particular, this length is in no manner dependent on a particular pitch. Rather, any length can be realized so as to provide a carrier suitable for any number of telecommunications modules and/or wire guides and/or further components. As an example, the telecommunications module disclosed in the WO 2003/061303 can be mounted to the carrier. In particular, the structure of this known telecommunications module in general, and with regard to the wire guides, can be used as a reference, which is incorporated herein, for the structures described herein. As regards the versatility, it should be emphasized that the telecommunications modules can be used without any wire guides. Further, one wire guide comprising any suitable number of wire guiding channels can be combined with a telecommunications module. Two wire guides as described above can be provided adjacent the telecommunications module on each side thereof. Furthermore, two wire guides can be arranged on the same side of a telecommunications module. Finally, plural wire guides can be arranged adjacent any desired sides of a particular telecommunications module.

It is, furthermore, beneficial for the carrier that the bars are arranged so as to define at least two planes. These planes can be used to provide defined mounting locations for specific parts of telecommunications modules or further components to be mounted thereon. As mentioned above, telecommunications modules can be directly or indirectly mounted to two bars defining a front plane. Two further bars, defining a backplane substantially parallel to the front plane, can be used to hold a printed circuit board. The printed circuit board can be provided with connectors and suitable components. For example, printed circuit boards can be connected with the connectors, on the one hand, and the telecommunications modules at their rear side, on the other hand. Thus, an assembly of plural telecommunications modules can be connected with each other in a flexible and reliable manner. These advantages are obtained by the versatile carrier having a modular structure being comprised of very few basic elements, such as the bars and those components connecting the bars with each other. Finally, that bar or those bars which is/are intended to mount telecommunications modules thereon can be constituted by a bar such as the product Flexirail offered by 3M/Quante AG, of Neuss, Germany.

Although the carrier can have any suitable number of bars in at least two planes, it is currently preferred that four bars are provided which define, in cross-section, a rectangular structure. As mentioned above, the cross-section is obtained from a section perpendicular to the extension of the bars. In the described rectangular structure two planes are provided which allow flexible mounting of different types of components such as telecommunications modules, on the one hand, and a printed circuit board, on the other hand, at different depths and/or levels.

In general, the bars can be of any cross-section and the mounting of the telecommunications modules can be adapted to allow the telecommunications modules to be mounted to bars of a certain cross-section. In particular, the bars can also have a profiled cross-section comprising suitable projections and/or undercuts for cooperating with structures like latch hooks and/or bulges of components, which are to be mounted to the bars. Telecommunications modules can be provided with suitable latch hooks. Furthermore, an adapter-bar or any other suitable intermediate element can be provided with one or more bulges cooperating with undercuts of the bars of the carrier. Thus, telecommunications modules can be directly attached to the bars. Furthermore, telecommunications modules can be indirectly attached to the bars by attaching one or more adapters to the bars, and mounting the telecommunications modules to the one or more adapters.

The bars can be maintained in a fixed relationship to each other, in particular, indirectly connected with each other by one or more plates or side walls. The plates can extend perpendicular to the direction of the bars and provide a simple and efficient connection of the bars as well as a type of closure at the sides of the carrier. Generally, the front and back as well as the top and bottom of the carrier are defined by the bars and remain open, and plates or walls are preferably used only at/as sides. The bars can, e.g. be connected with the plates by screws or clamps.

In practice, the carrier can comprise at least one adapter, which is attachable to one or more of the bars and adapted to mount telecommunications modules thereon. The adapter can have an elongate structure and be of substantially the same length as the bars. The adapter can have one or more projections or bulges which can cooperate with undercuts in the cross-section of the bars so as to allow the mounting thereof. Thus, the bar is appropriately shaped or profiled to allow the adapter to be mounted thereon. As an alternative, the adapter can have an appropriate shape or profile to allow the mounting thereof to the bar. Finally, any type of cooperating structure, both on the bar and the adapter, can be used. It should also be mentioned that there can be more than one adapter or intermediate element provided on a single bar to allow the mounting of telecommunications modules to one of the adapters or intermediate elements.

In particular, the adapter can be mounted to the bar by being slid into a profiled section of the bar, e.g. so as to accommodate the bulges and/or projections of the adapter in the undercut of the bar. The adapter can, as seen in the cross-section, provide a suitable projection or flange so as to allow telecommunications modules having latch hooks to be mounted thereon.

The carrier can comprise one or more printed circuit boards. One printed circuit board can be provided at a rear side of the carrier so as to constitute a so-called backplane. The printed circuit can be mounted directly to one or more bars. Alternatively, adapters or intermediate elements, as described above, can be used for this purpose. In the case of a backplane, the printed circuit board extends essentially parallel with the bars. This allows plural telecommunications modules, which can have integrated printed circuit boards for various purposes, to be connected with each other. In particular, portions of the telecommunications modules or the printed circuit boards thereof, can be connected with connectors, which can be provided on the printed circuit board constituting the backplane. As apparent, one or more printed circuit boards can thus be provided in an orientation substantially perpendicular to the extension of the bars. As described below, these can be guided by suitable guides. In particular, the last mentioned printed circuit boards can be used to carry splitter circuits. Splitter circuits are now widely used in ADSL-technology. This technology allows at least two different signals to be transmitted by a single line. This is achieved by transmitting the different signals at different frequencies along the same line. The signals are combined at a particular point in the telecommunications line. The combined signal is split at another point. In particular, at the subscriber side, voice and data signals, which are separate, are combined and sent to the central office via the same line. In the central office the combined signal is split. For the transmission of voice data signals to the subscriber, separate voice and data signals are combined at the central office, sent to the subscriber and split at the subscriber side. After splitting the signal, the so-called POTS (plain old telephone service) signal can be used to transmit voice. Furthermore, the remaining parts of the split signal can be used to transmit data, for example. The splitters, which are used to split or combine the signal, can be provided by suitable circuits on printed circuit boards, which can be accommodated in the carrier, as described above.

Moreover, printed circuit boards can be used in a configuration integrated with a telecommunications module or not, to provide a switch or relay matrix which allows for test and monitoring access to the contacts of a telecommunications module as well as to lines connected therewith. Furthermore, other active electronic parts, such as a multiplexer or a DSLAM can be integrated with a telecommunications module. One or more printed circuit boards can be used in this context. In any case, a further printed circuit board defining a backplane can provide a test bus for accessing selected contacts of selected telecommunications modules. For further details of such a test and monitoring access system, reference is made to the WO 03/079599, the contents of which are incorporated herein by reference. As mentioned, the one or more printed circuit boards of the carrier can have one or more connectors to advantageously establish connections with other components, such as further printed circuit boards.

The carrier can further comprise at least one guiding element attachable to at least one of the bars. The guiding elements can be flexibly mounted to any desired and suitable location on the bars to provide a guide for a printed circuit board and/or wire guides as described below. As an alternative, one or more bars can have guiding elements integrated therewith.

Thus, the guiding element can be adapted to guide one or more printed circuit boards so that a guiding element can extend between two bars in a direction perpendicular to the bars and can comprise a suitable slit along its extension. A printed circuit board can be inserted into the slit with its edge and can thus be guided.

The guiding element can, furthermore, be adapted to guide one or more wire guides. As will be apparent to those skilled in the field of telecommunications, wire guides can be constituted by two plates between which walls are formed so as to define channel-like structures. These channels extend from one side which is defined in a particular plane, to another side defined in a plane substantially perpendicular to the first mentioned plane. Due to the preferably arch-shaped structure of the interior walls, wires can be guided from one side to a second side that is substantially perpendicular to the first side. In the carrier described herein, such wires guides can be accommodated in an orientation with the bars being substantially perpendicular to the sides of the wire guide. As described above, wire guides of different types and/or different thicknesses, (in the direction of the bars) can flexibly be mounted to the carrier. In particular, the wire guides having arch-shaped channels, can be used, for example, to guide wires from the top or the bottom of the carrier to a front side, at which telecommunications modules are mounted, the contacts of which are exposed so as to connect the wires therewith. As will be apparent to those skilled in the art, the channels can be provided with a curve in any suitable manner. In particular, they could also be quarter-circular. Turning back to the guiding elements described above, these can be provided in an orientation essentially perpendicular to the bars, so as to guide the described wire guides. A guiding element, which is adapted to guide both a printed circuit board and a wire guide, can also be provided.

In particular, the guiding element can be adapted to guide a printed circuit board and one or more cables in parallel directions. In other words, a slit, in which a printed circuit board can be guided by engagement with its edge(s), can extend in parallel to an opening and/or a passage, through which cables can be guided.

Furthermore, a guiding element, which can be adapted to guide a wire guide, can comprise at least one opening. Such an opening can advantageously be used to allow the insertion of wires into the channels of the wire guide.

Whereas the carrier described herein can, e.g. by the above-mentioned guiding elements, be prepared to be provided with wire guides, to provide the function of guiding the wire in the carrier described herein, the latter comprises at least one wire guide integrated therewith.

As will be apparent from above, a distribution point in the field of telecommunications technology can be provided with enhanced flexibility by utilizing at least one carrier in one of the above-described feature combinations and at least one telecommunications module in order to allow, eventually, the flexible connection of subscriber lines with the exchange.

### Brief description of the drawings

Hereinafter, the invention will be described by several, nonlimiting examples thereof with reference to the drawings, in which:
Fig. 1 shows a perspective view of the carrier;
Fig. 2 shows a sectional view of the carrier;
Fig. 3 shows a sectional view of the carrier including several components mounted thereon;
Fig. 4 shows a top view of the carrier of Fig. 3;
Fig. 5 shows a sectional view of a further carrier including several components mounted thereon;
Fig. 6 shows a schematic view of a wire guide;
Fig. 7 shows a top view of a carrier including, amongst other things, wire guides;
Fig. 8 shows a side view of a guiding element for guiding a printed circuit board;
Fig. 9 shows a top view of the element of Fig. 8;
Fig. 10 shows a sectional view of the elements of Figs. 8 and 9 together with a portion of a printed circuit board; and
Fig. 11 shows a top view of a guiding element for guiding wire guides.

### Description of Preferred Embodiments of the Invention

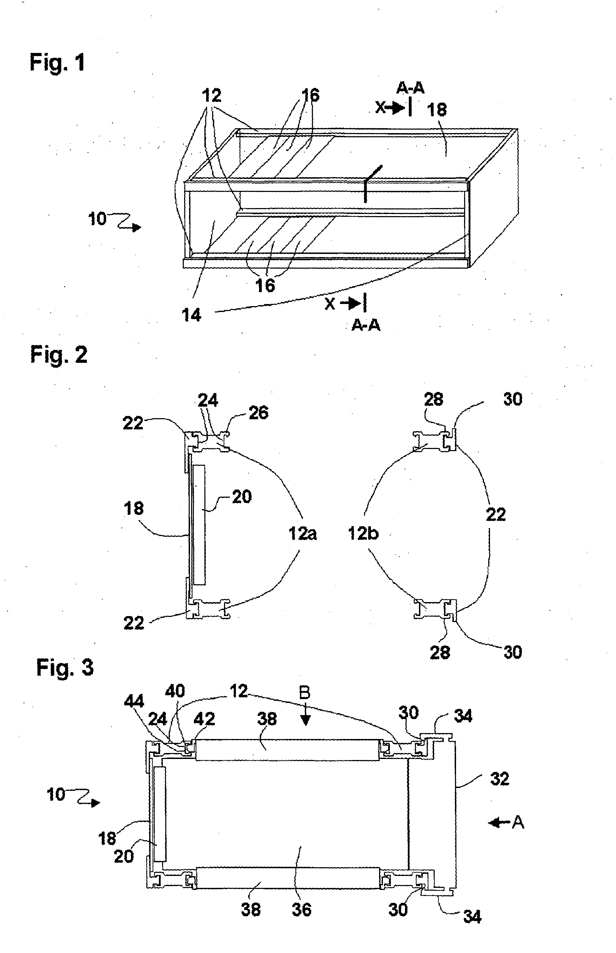

In one embodiment, the carrier 10, as shown in a perspective view in Fig. 1, generally consists of four bars 12, which are arranged substantially parallel to each other so as to form a generally open frame having a rectangular cross-section, as can be seen from the sectional view of Fig. 2. The bars 12, which could also be called support bars or rods, are maintained in a fixed relationship to each other by two side plates 14, to each of which each bar 12 is connected at an end thereof. As will be described in more detail below, guiding elements 16, which are constituted by so-called grid plates, are mounted to the carrier by being attached to two bars 12 each. In the embodiment shown, a printed circuit board 18 is provided at a rear side of the carrier 10 so as to define a so-called backplane. The carrier having this general structure can be mounted in a rack or sub-rack of any type of distribution point so as to allow telecommunications modules to be mounted thereon as will be described in more detail below.

Fig. 2, which is a sectional view through A-A perpendicular to the extension of the bars 12, from direction X, shows the four bars 12 of the embodiment shown which are arranged to define, as regards a cross-section, a rectangle. In the typical orientation two bars, in the drawings of Fig. 2 the bars 12b at the right side, define a front plane, whereas the other two bars 12a in Fig. 2 define a backplane. In the embodiment shown, the backplane is, furthermore, provided with a printed circuit board 18. As can be taken from Fig. 2, one or more connectors 20 can be provided on the printed circuit board 18 and can, for example, be soldered thereto

In the embodiment shown, the printed circuit board 18 is mounted to the bars 12 by suitable adapters 22, each of which is connected with one of the bars 12. For the purpose of attaching the adapters 12 as well as further components, as described in more detail below, to the bars 12, each of the bars 12 has a specific profile. In particular, the profile is, in the cross-section as seen in Fig. 2, preferably, but not necessarily, rectangular with two generally U-shaped sections 24 at two opposite sides. In the embodiment shown, at least one of the legs 26 of the U-shaped section 24 has a portion extending towards the opposite leg. Thus, an undercut is provided, into which a substantially complimentary section of the adapter 22 including a protrusion, can be slid. In other words, the bar 12 and the adapter 22 are brought in an orientation parallel to each other and aligned as shown in Fig. 2 so that the adapter 22 can be slid into the complementary section of the bar 12 in a direction perpendicular to the plane of the paper of Fig. 2. In this manner, during the preparation of the carrier 10, a reliable connection can be established between the bar 12 and the adapter 22.

In the embodiment shown, the bars 12b on the right side, i.e. those bars which define a front plane, have, at their front side, i.e. the right side of Fig. 2, a U-shaped section 24 having legs 28, both of which comprise a portion being directed to the opposite leg 28. Thus, a structure is defined into which an adapter 22 of a different type can be slid as described above for the adapter 22 of the left side. It should be mentioned, that the attachment structure can be the same or different for all adapters 22. To allow telecommunications modules to be mounted by utilizing the adapters 22 of the right side, these adapters comprise a flange 30 extending parallel to the imaginary front plane and defining a projection for mounting telecommunications modules thereon.

Fig. 3 illustrates another embodiment, in which the carrier 10 of the previous figures is shown in combination with, amongst other things, a typical telecommunications module 32. This telecommunications module 32 comprises at each side thereof, i.e. the upper and lower side according to Fig. 3, a flexible latch hook 34 for cooperation with the flange 30. As can be taken from the drawings, the telecommunications module 32 is mounted to the carrier 10 by movement in the direction of arrow A. In the course of this movement, the latch hooks 32 will be deflected by engagement with the edges of the flanges 30 and will, due to the flexibility provided by utilizing, e.g. plastic for the latch hooks 34, return to the position as shown in Fig. 3. In this position, the latch hooks will engage the flanges 30 and prevent the telecommunications module 32 from being taken out, i.e. being moved opposite to the direction of A. However, if a disassembly of a telecommunications module is intended, the latch hooks 34 are disengaged and taken off by moving the telecommunications module opposite to the direction of arrow A.

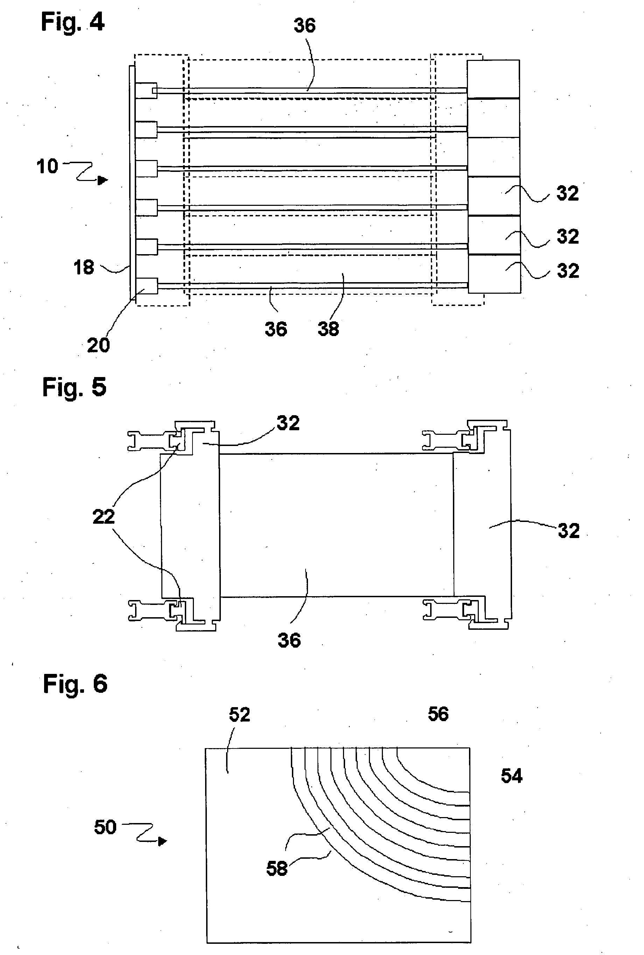

In the embodiment of Fig. 3, a printed circuit board 36 is provided between the telecommunications module 32 and the connector 20 of the backplane 18. As the skilled person will realize, the printed circuit board 36 has a considerable dimension in the plane of Fig. 3, whereas it has a comparatively small thickness, i.e. a small extension in a direction in which the bars 12 extend. Thus a suitable guiding can be provided by guiding elements 38, which are; in the embodiment shown, each provided between two bars 12. As will become apparent more clearly from Fig. 4, the guiding elements 38 are elongate elements extending between the two bars 12. On that side, which faces the printed circuit board 36, each guiding element 38 is provided with a slot (not shown). In order to guide the printed circuit board 36, each slot has a width substantially identical or somewhat larger than the thickness of the printed circuit board 36. In this manner, the printed circuit board 36 can be inserted with its opposite edges between the guiding elements 38 and can be securely guided by these elements.

At the sides of the guiding elements 38 as seen in Fig. 3, these guiding elements 38 can be attached to the bars 12 by a suitable clip. For this purpose, a suitable projection 40 is connected with the remainder of the guiding element 38 via thin joint 42. In this manner, the projection 40 can easily be deflected when the guiding element 38 is to be attached to the bars 12 by being moved in the direction of arrow B. When the projection 40 encounters the upper edge of the bar 12 it will, assisted by a taper 44, be somewhat deflected to the inside, i.e. towards the remainder of the guiding element 38, so that it can pass the edge of the bar 12 and enter the space defined by the U-shaped section 24 of the bar 12. Thus, both guiding elements 38 can easily be attached to the bars 12 and provide guidance for the printed circuit board 36 inserted between two guiding elements 38.

Fig. 4 shows a top view of the carrier 10 of Fig. 3 in the direction of arrow B. For the sake of clarity, the upper two bars 12 and guiding elements 36 according to Fig. 3 are shown in dotted lines to clearly show the remaining components. In particular, it can be taken from Fig.4, that the printed circuit boards 36 are comparably thin and are, in the embodiment shown, each connected with a connector 20 of the backplane 18. As can also be seen from Fig. 4, several telecommunications modules 32 are mounted at the front side directly adjacent each other. Therefore, the pitch is defined by the width of each telecommunications module alone. The width of the guiding elements 38 guiding the printed circuit board 36 is adapted thereto and allows flexible mounting of telecommunications modules 32 including printed circuit boards 36 connected therewith. Furthermore, this can achieve a high capacity. In other words, a high number of telecommunications modules can be mounted to the carrier in a given space. When the backplane 18 comprises one or more connectors 20, the backplane 18 has to be changed or adapted to a situation, in which additional printed circuit boards are to be connected with the backplane 18 or are arranged at a different distance from each other. However, when the backplane lacks connectors 20 as well as in a case, where the positions of connectors 20 match a different arrangement of printed circuit boards connected therewith, the backplane does not necessarily have to be adapted to such a change. In the situation of Fig. 4, the guiding elements 38 can also define the pitch, i.e. the distances at which telecommunications modules 32 can be arranged. This means, however, that any desired pitch can be realized by guiding elements which are adapted in a suitable manner.

This advantage can also be realized by the embodiment of Fig. 5, in which telecommunications modules 32 are not only mounted to a front side, but also at the rear side. The mounting structure in detail, including adapters 22 is, in the embodiment shown, identical for the telecommunications module 32 of the backside. As shown in Fig.5, a printed circuit board 36 can extend between the telecommunications modules 32 of the front and the rear side.

Fig. 6 shows schematically the structure of a wire guide 50. As mentioned above, the wire guide 50 can generally be formed like those wires guides, which are derivable from the above-mentioned WO 2003/061303. The wire guide 50 preferably consists of two substantially rectangular plates 52, one of which is visible in Fig. 6. The second plate 52 will in the completed wire guide 50 be arranged substantially parallel to the plate 52 which can be seen in Fig. 6 and will be spaced apart there from a few millimeters in the direction of the viewer. In order to guide wires from a first, e.g. front side 54 to a second, e.g. topside 56, several arch-shaped walls 58 are formed so as to extend from the first 54 to the second side 56. The arch-shaped walls 58 are substantially arranged so as to constitute concentric arches, at least portions of which can correspond to quarter circles. Fig. 6 is a merely schematic view and that any other number and shape of arch-shaped walls 58 as well as wire guiding channels defined thereby are possible. In particular, the wire guiding channels can even be straight so as to guide wires from a front to a rear of the carrier. It is, furthermore, evident from Fig. 6 that the very same wire guide can be turned 180° about a horizontal axis so as to guide wires to and from a bottom side instead of a top side as shown for the orientation of Fig. 6. Thus, the wire guides are standardized and can be flexibly used with suitable guiding elements in the novel carrier. In this context, other shapes of the wire guiding channels are possible, so that other angles of turning the wire guides, in order to guide the wires to other sides, are possible.

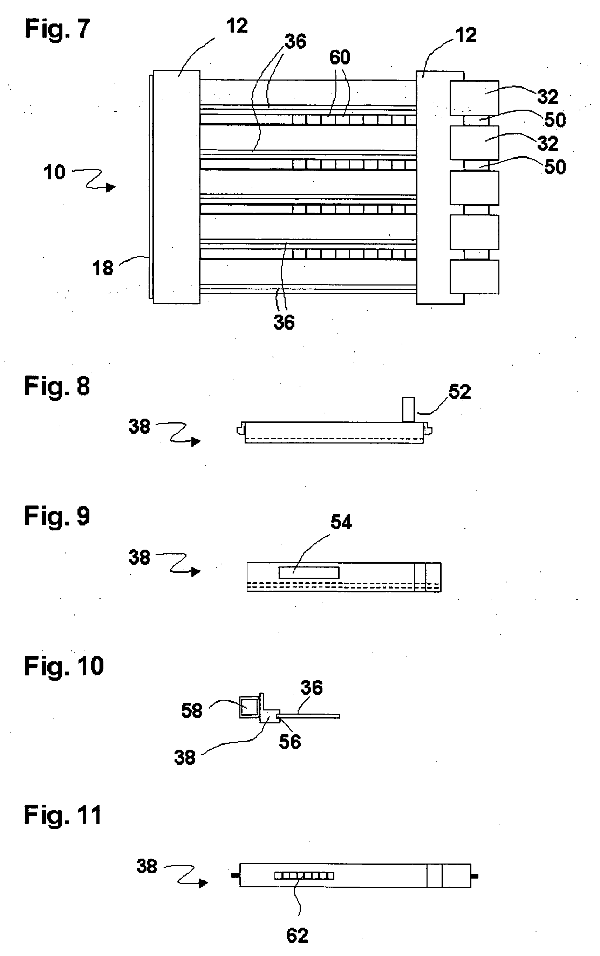

As can be taken from Fig. 7, which is a view similar to that of Fig. 4 and additionally shows the wire guides of Fig. 6, the wire guides 50 are comparably thin and arranged between the telecommunications modules 32. In the top view of Fig. 7, the bars 12 of the topside are also visible. It is, furthermore, apparent that the openings 60 of the wire guides 50, which are drawn schematically only for the top two wires guides, are exposed at the topside. In this manner wires can be inserted into the openings 60 and are guided to the front side (the right side of Fig. 7) so as to be connected with contacts of the telecommunications modules. As can be seen from a comparison between Fig. 7 and Fig. 4, the printed circuit boards 36 extending between the telecommunications modules 32 and the plane 18 are also present.

Fig. 8 shows a side view of a guiding element 38, which is adapted to guide a printed circuit board 36 as shown in Fig. 3. The clipping mechanism is clearly visible. Furthermore, Fig. 8 shows a lug 52, which serves to guide external wires or cables.

Fig. 9 shows a top view of guiding element 38. In this embodiment, an opening 54 is provided, which enables a connector such as a connector of the sub-D-type to be inserted and to be connected with a complementary connector provided on the printed circuit board.

Fig. 10 shows a sectional view of a further embodiment of a guiding element 38 in a state in which a printed circuit board 36 is guided. As can be taken from Fig. 10, the guiding element 38 comprises a slot 56, into which the edge of the printed circuit board 36 is inserted. In the embodiment of Fig. 10, the guiding element is provided with an internal opening 58, which serves as a cable guide in order to guide cables in the direction parallel to the extension of the guiding element 38, i.e. perpendicular to the plane of Fig. 10.

Finally, Fig. 11 shows a top view of a guiding element 38 adapted to guide wire guides such as that shown in Fig. 6. In order to allow wires to pass through, openings 62 corresponding to the openings of the wire guides are provided. To facilitate the guiding of the wire guides by the guiding elements 38, the wire guide 50 can have a thin protrusion extending from its edge, the protrusion generally corresponding to the edge of a printed circuit board 36. Thus, this protrusion can be inserted into a suitable slot 56 of the guiding elements in order to achieve the guiding function.

As regards the materials used, the bars 12 and plates 14 can be made of metal. The plates 14 can be made of sheet metal. The bars can be made of extruded metal, such as aluminum. The adapters 22, guiding elements 38 and wire guides 50 can be made of plastic. Furthermore, the housing of the telecommunications modules 32 can be made of plastic.

As can be seen from the foregoing, e.g. a comparison of Figs. 4 and 7, the carrier 10 is extremely versatile in that any desired number of telecommunications modules, wire guides and further desired components can be arranged in a adjacent arrangement in any desired order.

## Claims

1. A carrier (10) of a distribution point in the field of telecommunications, the carrier (10) having a generally open, frame-like structure with at least three substantially parallel bars (12) arranged in at least two planes, the bars being maintained in a fixed relationship to each other, and at least one of the bars (12) being adapted to mount telecommunications modules (32) thereon.

2. The carrier according to claim 1 wherein the carrier comprises four substantially parallel bars (12) defining, as seen in a cross-section, a rectangular structure.

3. The carrier in accordance with claim 1 or 2 wherein the bars (12) have a profiled cross-section.

4. The carrier in accordance with any of the preceding claims wherein the bars (12) are connected by plates (14).

5. The carrier in accordance with any of the preceding claims wherein the carrier (10) further comprises at least one adapter (22) which is attachable to a bar (12) and adapted to mount the telecommunications modules (32) thereon.

6. The carrier in accordance with claim 5 wherein the adapter (22) is attachable to a bar (12) by being slid into a profiled section of the bar (12).

7. The carrier in accordance with any of the preceding claims further comprising at least one printed circuit board (18, 36).

8. The carrier in accordance with any of the preceding claims further comprising at least one guiding element (38) attachable to at least one bar (12).

9. The carrier in accordance with claim 8, wherein the guiding element (38) is adapted to guide a printed circuit board (36).

10. The carrier in accordance with claim 8 or 9, wherein the guiding element (38) is adapted to guide a wire guide (50)

11. The carrier in accordance with any of claims 8 to 10 wherein the guiding element (38) is adapted to guide a printed circuit board (36) and one or more cables in parallel directions.

12. The carrier in accordance with any of claims 8 to 11 wherein the guiding element (38) comprises at least one opening (60).

13. The carrier in accordance with any of the preceding claims further comprising at least one wire guide (50).

14. Distribution point in the field of telecommunications comprising at least one carrier (10) in accordance with any of the preceding claims and at least one telecommunications module (32).
